Europäisches Patentamt

European Patent Office

Office européen des brevets

(19)

(11) **EP 0 643 486 B1**

(12) **EUROPEAN PATENT SPECIFICATION**

(45) Date of publication and mention
of the grant of the patent:
**11.12.1996 Bulletin 1996/50**

(51) Int Cl.⁶: **H03K 17/22**, H03K 17/284,
G05F 1/46

(21) Application number: **93202634.7**

(22) Date of filing: **10.09.1993**

(54) **Reference voltage generating circuit**

Referenzspannungsgeneratorschaltung

Circuit générateur de tension de référence

(84) Designated Contracting States:
**BE DE ES FR GB IT NL SE**

(43) Date of publication of application:
**15.03.1995 Bulletin 1995/11**

(73) Proprietor: **ALCATEL BELL**
**Naamloze Vennootschap**
**B-2018 Antwerpen 1 (BE)**
Designated Contracting States:
**BE DE ES FR GB IT NL SE**

(72) Inventors:
• **Louagie, Filip Marcel**
**B-8800 Roeselare (BE)**

• **Haspeslagh, Didier René**
**B-8530 Harelbeke (BE)**

(56) References cited:
**EP-A- 0 396 812**

• **IBM TECHNICAL DISCLOSURE BULLETIN vol.**
**32, no. 8B , January 1990 , Armonk, NY, US, pp.**
**319-321; 'DELAY START AND CONTROL OFF'**
• **PATENT ABSTRACTS OF JAPAN vol. 9, no. 56**
**(E-302)(1779) 12 March 1985 & JP-A-59 198 024**
• **PATENT ABSTRACTS OF JAPAN vol. 8, no. 53**
**(E-231)(1490) 9 March 1984 & JP-A-58 206 230**

## Description

The present invention relates to a reference voltage generating circuit fed from a voltage supply source providing across first and second poles a first supply voltage which increases to a substantially constant value.

Such a reference voltage generating circuit is already known in the art and may for instance he built from the series coupling of first and second resistances across the first and second poles, the reference voltage being provided across the second resistance. This reference voltage then is constituted by a predetermined fraction of the average supply voltage. In order to filter fluctuations from this supply voltage so as to prevent them from appearing in the reference voltage, a capacitance may be provided in parallel with the second resistance. However, when the reference voltage generating circuit is switched on, i.e. when the supply voltage is first applied to it, this capacitance causes the above predetermined fraction to be only reached after a delay period. Indeed, the reference voltage only increases towards this predetermined fraction with a time constant equal to

$$\tau = \frac{C \times R1 \times R2}{R1+R2}$$

where R1 and R2 are the respective values of the first and second resistances and C is the value of the capacitance. To be noted that the lower this time constant, i. e. the lower the mentioned delay period, the less fluctuations of the supply voltage are filtered.

JP-A-59 198 024 discloses a circuit fed from a voltage source providing across first and second poles a suppy voltage, which increases to a constant value. The circuit includes two voltage dividers comprising each two resistors in series and delivering two reference voltages to a differential amplifier. This signal is used via on OR gate to trigger a latch circuit which generates a reset pulse.

EP-A-0 396 812 discloses two voltage dividers generating each a reference voltage. These voltages are fed to a comparator which delivers a signal following the supply voltage from a time t2.

An object of the present invention is to provide a reference voltage generating circuit of the above known type wherein fluctuations of the supply voltage are filtered, but wherein the reference voltage reaches a predetermined fraction of the supply voltage faster than in a resistive divider solely consisting of two resistances and a filtering capacitance.

According to the invention, this object is achieved due to the fact that said reference voltage generating circuit includes :

- between said first and second poles the series connection of a first resistance and of a second resistance which is shunted by a capacitance across which said reference voltage is generated;
- a switch connected in parallel with said first resistance;
- also between said first and second poles the series connection of a third resistance and of a fourth resistance across which an auxiliary voltage is developed, the ratio of said first and second resistance values being equal to that of said third and fourth resistance values; and
- a comparator comparing said reference and auxiliary voltages and controlling said switch such that it short-circuits said first resistance when said reference voltage becomes lower than said auxiliary voltage said reference voltage thus following said auxiliary voltage.

In this way, when the switch is open the reference voltage increases with the above mentioned time constant

$$\tau = \frac{C \times R1 \times R2}{R1+R2}$$

to a voltage - the intended predetermined fraction of the supply voltage - which is equal to the auxiliary voltage and which is given by

$$VS \times \frac{R2}{R1 + R2},$$

where VS is the supply voltage. However, since the switch short-circuits the fourth resistance when the reference voltage becomes lower than the auxiliary voltage, the reference voltage increases with a time constant $\tau = C \times R_S$, where $R_S$ is the series resistance of the switch, towards the supply voltage instead of towards the auxiliary voltage. Thereby, as the latter time constant $\tau$ is very small, the reference voltage more rapidly reaches this auxiliary voltage. When the reference and auxiliary voltages are equal the comparator detects this and the switch is opened thereby again stabilizing the reference voltage.

An advantageous feature of the present invention is that said reference voltage generating circuit further includes a second switch in parallel to said fourth resistance and controlled by said comparator in such a way that said fourth resistance is short-circuited when at least said reference voltage is higher than said auxiliary voltage.

In this way, when the second switch is closed the reference voltage is compared to zero, whereby the comparator causes the first mentioned switch to be open since this reference voltage is always positive. Thereby, this first switch is prevented from being opened and closed repetitively. Indeed, when for instance the supply voltage is not constant but increasing and the first switch is opened because the auxiliary voltage is lower than the reference voltage, then the latter reference voltage follows the increasing supply voltage again with a time constant

$$\tau = \frac{C \times R1 \times R2}{R1 + R2}$$

as already discussed above, whereas the auxiliary voltage follows the supply voltage with a zero time constant. Thus, a short time later the reference voltage is again lower than the auxiliary voltage and the first switch closes again thus causing the reference voltage again to rise above the auxiliary voltage whereby the first switch opens again and so on. As a result, the filtering task of the capacitance is then disabled. By closing the second switch the capacitance again filters supply voltage variations so that they do not appear in the reference voltage. To be noted that the second switch is not allowed to be closed when the reference voltage has not yet reached the auxiliary voltage in order to comply with the object of fast reaching the predetermined fraction of the supply voltage.

A further advantageous feature of the present invention is that said reference voltage generating circuit is used in a start pulse generating circuit generating a start pulse when a second supply voltage provided across a third pole and said second pole reaches a predetermined value, said substantially constant value being reached before said predetermined value is reached, and said start pulse generating circuit further including :

- between said third and second poles the series connection of a fifth resistance and a sixth resistance across which a second auxiliary voltage is generated which reaches said reference voltage when said second supply voltage reaches said predetermined value; and

- a second comparator comparing said second auxiliary voltage and said reference voltage and generating said start pulse when said second auxiliary voltage reaches said reference voltage and controlling said second switch in such a way that said fourth resistance is short-circuited when at least said second auxiliary voltage is higher than said reference voltage.

In this way, the second switch is not closed before the second supply voltage has reached the predetermined value, i.e. the reference voltage is locked to the auxiliary voltage at least until the reset pulse is generated, after which the capacitance resumes its filtering operation.

Yet a further advantageous feature of the present invention is that said start pulse generating circuit further includes a supply voltage detection circuit controlling said second switch in such a way that said fourth resistance is short-circuited when at least said first mentioned supply voltage is higher than a predetermined threshold voltage.

In this way, the second switch is only allowed to be closed when at least the first supply voltage is sufficiently high. Thus, when the first supply voltage is provided by for instance a so-called thermal battery the behaviour of which is not well known at start up, i.e. until the first supply voltage has reached a sufficiently high level, this unknown behaviour is prevented from unwillingly closing the second switch which would again incur a delay before reaching the above mentioned predetermined fraction of the first supply voltage.

The above mentioned and other objects and features of the invention will become more apparent and the invention itself will be best understood by referring to the following description of an embodiment taken in conjunction with the accompanying drawing wherein :

Fig 1 represents a start pulse generating circuit using a reference voltage generating circuit according to the invention; and
Fig 2 shows a time diagram of different voltages in the start pulse generating circuit of Fig 1 when this start pulse generating circuit is started up.

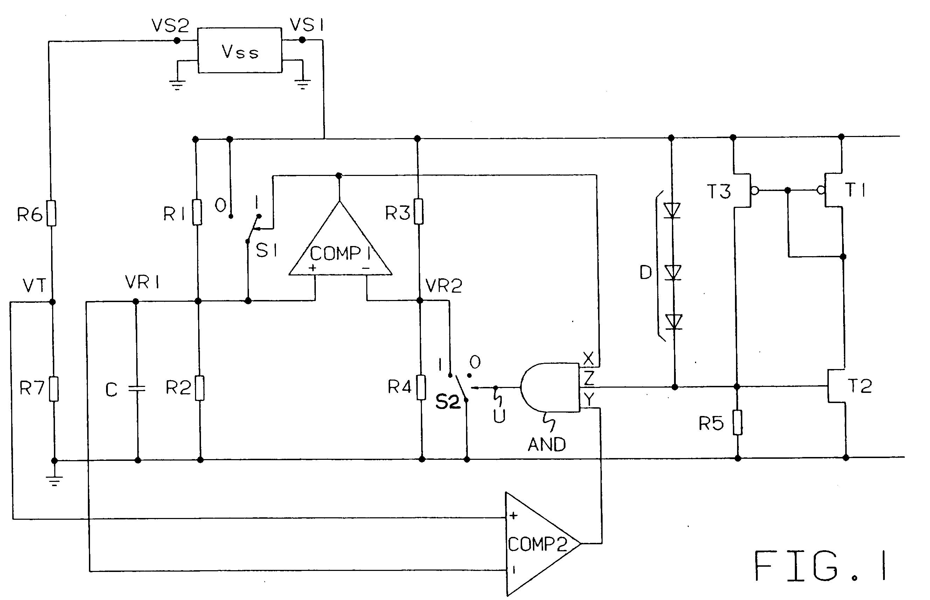

The start pulse generating circuit shown in Fig 1 includes a voltage supply source VSS providing a supply voltage VS1 across poles VS1 and ground, and a supply voltage VS2 across poles VS2 and ground. It further includes between the poles VS1 and ground a reference voltage generating circuit, a branch consisting of the series connection of main paths of a PMOS transistor T1 and an NMOS transistor T2, and a branch consisting of the series connection of the main path of a PMOS transistor T3 and a fifth resistance R5. The reference voltage generating circuit includes between the poles VS1 and ground a branch consisting of the series connection of first and second resistances R1 and R2, a branch consisting of the series connection of third and fourth resistances R3 and R4, a switch S1 connected in parallel to the resistance R1, a capacitance C connected in parallel to the resistance R2, a switch S2 connected in parallel to the resistance R4, and a comparator COMP1. The resistances R1 to R4 are chosen such that the ratio R1/R2 is equal to the ratio R3/R4. The connecting node VR1 of resistances R1 and R2 at which a like named reference voltage VR1 is provided, is connected to the non-inverting input of a comparator COMP1 whose inverting input is connected to the connecting node VR2 of resistances R3 and R4 at which a like named auxiliary voltage VR2 is provided. An output of comparator COMP1 controls the switch S1 in a way described later and is connected to a first input X of a three-input AND-gate AND whose output U, at which a like named logical voltage U constituting a start pulse, is provided controls the switch S2 in a way which is also described later. A diode means D consisting of the series connection of three diodes is connected in parallel to the main path of transistor T3. The gates of transistors T1 and T3 are interconnected and connected to the drain of transistor T1. The gate of transistor T2 is connected to the drain of transistor T3 and to a second input Z of the AND-gate AND. The start pulse generating circuit further includes between the poles VS2 and ground the series connection of sixth and seventh resistances R6 and R7, the connecting node VT of which at which a like named auxiliary voltage VT is provided, is connected to the non-inverting input of a second comparator COMP2. The inverting input of the comparator COMP2 is connected to the connecting node VR1 of resistances R1 and R2, and its output is connected to a third input Y of the AND-gate AND.

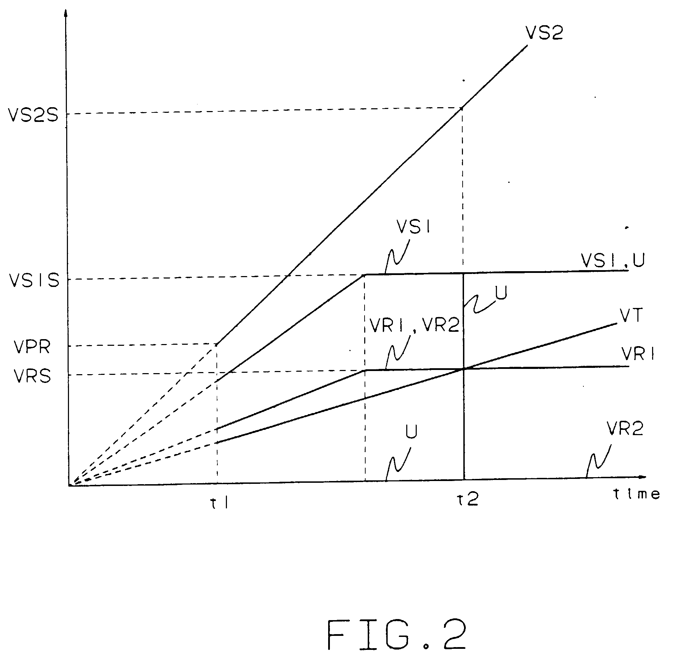

The behaviour of the voltages VS1, VS2, VR1, VR2, VT and U with respect to ground when the reference voltage generating circuit is started up, are shown in Fig 2.

The operation of the start pulse generating circuit is now described with reference to both Figs 1 and 2.

The voltage supply source VSS consists of a thermal battery and provides the voltage VS2 which has an unknown start-up behaviour until time t1 which corresponds to the voltage VS2 having reached a value VPR. The voltage VS1 is derived from VS2 and therefore VS1 also shows an unknown behaviour until t1 as do the voltages VR1, VR2 and VT since these are derived from respective first and second supply voltages VS1 and VS2. This unknown behaviour is schematically shown in Fig 2 by the dashed lines for the voltages VS1, VS2, VR1, VR2 and VT until time t1.

To be noted that the voltage VS1 is derived from the voltage VS2 by a DC voltage regulator as known in the art and is such that VS1 is finally limited at a substantially constant value VS1S. However, such a regulator is no object of the present invention and is therefore not discussed here.

The purpose of the Start pulse generating circuit is to provide a reset pulse at node U when the voltage VS2 reaches a predetermined value VS2S in order to then supply this voltage VS2 to a (not shown) electronic circuit. Thereby, too low a supply voltage which could cause this electronic circuit to work in a defective way is prevented from being supplied thereto. To this end the auxiliary voltage VT is compared to the reference voltage VR1, this auxiliary voltage being a fraction of the voltage VS2 which is determined such that it is equal to the reference voltage VR1 when the voltage VS2 reaches its predetermined value VS2S. The reset pulse U is generated when the three following conditions are satisfied. Firstly, time tl has to be elapsed, which is assured by the circuit part consisting of transistors T1 to T3, resistance R5 and diode means D. Secondly, the reference voltage VR1 has to have reached the above predetermined fraction of the supply voltage VS1, so that the capacitance C may resume its filtering effect, which is assured by the reference voltage generating circuit. Thirdly, the voltage VS2 must have reached it value VS2S which is assured by the circuit part consisting of resistances R6 and R7 and comparator COMP2.

When the reference voltage generating circuit is started up the supply voltage VS1 shows a behaviour as represented in Fig 2. When the switch S2 is open the voltage VR2 is equal to

$$VS1 \times \frac{R4}{R3 + R4}.$$

On the other hand when the switch S1 is open the voltage VR1 goes to

$$VS1 \times \frac{R2}{R1 + R2}$$

which is equal to VR2 since R1/R2 is equal to R3/R4, but with a time constant equal to

$$\tau = \frac{C \times R1 \times R2}{R1 + R2}.$$

As a consequence the voltage VR1 is lower than the voltage VR2 and the output of the comparator COMP1 is equal to zero whereby the switch S1 is closed (0). Furthermore, the output of the comparator COMP1 is applied to the AND-gate AND whose output thus is a logical zero whereby switch S2 is open (0). Since switch S1 is closed the voltage VR1 increases to VS1 with a time constant equal to $\tau = C \times R_S$ where $R_S$ is the series resistance of the switch S1, i.e. with a time constant which is substantially zero. Thereby, the voltage VR1 increases until it becomes higher than the voltage VR2. At that moment, the output of the comparator COMP1 switches from low to high and switch S1 opens again (1). As a consequence the voltage VR1 from then on again increases with the above time constant

$$\tau = \frac{C \times R1 \times R2}{R1 + R2}$$

to the voltage VR2. When the switch S2 remains open (0), which until time t2 is the case as is shown hereinafter, then, when the supply voltage VS1 is still increasing, the voltage VR1 is some time later again lower than the voltage VR2 and the comparator COMP1 again switches from high to low. This process is repeated until the switch S2 is closed. Then the voltage VR2 becomes equal to zero so that the voltage VR1 is compared to zero and, since VR1 is always positive, the output of the comparator COMP1 is always high so that the switch S1 is always open and the voltage VR1 follows the value

$$VS1 \times \frac{R2}{R1 + R2}$$

with the already mentioned time constant

$$\tau = \frac{C \times R1 \times R2}{R1+R2},$$

i.e. the voltage VR1 then constitutes a stabilized reference voltage.

The switch S2 is closed when not only the output of the comparator COMP1 is high, but when also the voltage at the drain of transistor T3 is high and the output of comparator COMP2 is high.

The voltage at the drain of transistor T3 being high assures the start up behaviour of the thermal battery to have elapsed. Indeed, as long as the voltage VS1 is lower than the sum of the forward voltage drops of the diodes constituting the diode means D, no current flows therethrough. Thereby, the voltage at the gate of transistor T2 is zero and T2 is not conductive so that also T1 and T3 are not conductive. When the voltage VS1 is high enough, a current starts flowing through the diode means D and through R5. When this current is high enough transistor T2 is switched on, pulling the gates of transistors T1 and T3 low whereby these are also switched on and both a current through T1 and T3 starts flowing. The current through transistor T3 also flows through resistance R5 whereby the voltage at the gate of transistor T2 increases even more, the mentioned currents increasing even more and the voltage across R5 thus increasing so that it finally constitutes a logical high input for the AND-gate AND, thus allowing for the switch S2 to be closed. In this way, the voltage at the drain of transistor T3 is only high when the supply voltage VS1 is high enough which assures the start up behaviour of the thermal battery to have elapsed.

The output of the comparator COMP2 being high assures the voltage VS2 to have reached the value VS2S. Indeed, the ratio of the resistances R6 and R7 is chosen such that the voltage VT reaches the reference voltage VR1 when the voltage VS2 reaches the value VS2S, at which moment the output of the comparator COMP2 switches from low to high.

To be noted that to this end the ratio of R6 and R7 is to be chosen equal to

$$\frac{R6}{R7} = (1 + \frac{R1}{R2}) \times \frac{VS1S}{VS2S} - 1.$$

Thus, the switch S2 is only closed and the reset pulse U is only generated after time tl, when the above mentioned three conditions are satisfied, VR1 then being higher than VR2, and VS2 having reached VS2S.

While the principles of the invention have been described above in connection with specific apparatus, it is to be clearly understood that this description is made only by way of example and not as a limitation on the scope of the invention, which is defined by the appended claims.

**Claims**

1. Reference voltage (VR1) generating circuit fed from a voltage supply source (VSS) providing across first (VS1) and second (ground) poles a first supply voltage (VS1) which increases to a substantially constant value (VS1S), wherein said reference voltage generating circuit includes :

   - between said first (VS1) and second poles (ground) the series connection of a first resistance (R1) and of a second resistance (R2) which is shunted by a capacitance (C) across which said reference voltage (VR1) is generated;
   - a switch (S1) connected in parallel with said first resistance (R1);
   - also between said first (VS1) and second poles (ground) the series connection of a third resistance (R3) and of a fourth resistance (R4) across which an auxiliary voltage (VR2) is developed, the ratio of said first (R1) and second (R2) resistance values being equal to that of said third (R3) and fourth (R4) resistance values; and
   - a comparator (COMP1) comparing said reference (VR1) and auxiliary (VR2) voltages and controlling said switch (S1) such that it short-circuits said first resistance (R1) when said reference voltage (VR1) becomes lower than said auxiliary voltage (VR2), said reference voltage (VR1) thus following said auxiliary voltage.

2. Reference voltage (VR1) generating circuit according to claim 1, characterized in that it further includes a second switch (S2) in parallel to said fourth resistance (R4) and controlled by said comparator (COMP1) in such a way that said fourth resistance (R4) is short-circuited when at least said reference voltage (VR1) is higher than said auxiliary voltage (VR2).

3. Reference voltage (VR1) generating circuit according to claim 2, characterized in that it is used in a start pulse generating circuit generating a start pulse (U) when a second supply voltage (VS2) provided across a third pole (VS2) and said second pole (ground) reaches a predetermined value (VS2S), said substantially constant value (VS1S) being reached before said predetermined value (VS2S) is reached, and said start pulse generating circuit further including :

   - between said third (VS2) and second poles (ground) the series connection of a fifth resistance (R6) and a sixth resistance (R7) across which a second auxiliary voltage (VT) is generated which reaches said reference voltage (VR1) when said second supply voltage (VS2) reaches said predetermined value (VS2S); and

- a second comparator (COMP2) comparing said second auxiliary voltage (VT) and said reference voltage (VR1) and generating said start pulse (U) when said second auxiliary voltage (VT) reaches said reference voltage (VR1) and controlling said second switch in such a way that said fourth resistance (R4) is short-circuited when at least said second auxiliary voltage (VT) is higher than said reference voltage (VR1).

4. Reference voltage (VR1) generating circuit according to claim 3, characterized in that said start pulse generating circuit further includes a supply voltage detection circuit controlling said second switch (S2) in such a way that said fourth resistance (R4) is short-circuited when at least said first mentioned supply voltage (VS1) is higher than a predetermined threshold voltage.

5. Reference voltage (VR1) generating circuit according to claim 4, characterized in that said supply voltage detection circuit includes between said first (VS1) and second poles (ground) a first branch constituted by the series coupling of main paths of a first transistor (T1) of a first polarity and of a second transistor (T2) of a second polarity, and a second branch constituted by the series coupling of a main path of a third transistor (T3) of said first polarity and a fifth resistance (R5), control electrodes of said first (T1) and third transistors (T3) being interconnected and connected to the coupling node of said first (T1) and second transistors (T2), a control electrode of said second transistor (T2) being coupled to the coupling node between said third transistor (T3) and said fifth resistance (R5) and via a diode means (D) to said first pole (VS1), the latter coupling node constituting an output of said supply voltage detection circuit.

6. Reference voltage (VR1) generating circuit according to claim 5, characterized in that said second switch (S2) is controlled by an output of a logical AND-gate (AND), a first input of which is coupled to an output of said first mentioned comparator (COMP1), a second input of which is coupled to an output of said supply voltage detection circuit, and a third input of which is coupled to an output of said second comparator (COMP2).

**Patentansprüche**

1. Referenzspannungs- (VR1) Erzeugungsschaltung, die von einer ersten Versorgungsspannungsquelle (VSS) gespeist wird, die über ersten (VSS) und zweiten (Masse) Polen eine erste Versorgungsspannung (VS1) bereitstellt, welche auf einen im wesentlichen konstanten Wert (VS1S) ansteigt, wobei die Referenzspannungs-Erzeugungsschaltung enthält:

- zwischen dem ersten (VS1) und dem zweiten Pol (Masse) die Reihenschaltung eines ersten Widerstandes (R1) mit einem zweiten Widerstand (R2), wobei eine Kapazität (C) zu dem zweiten Widerstand parallel liegt, über welchen die Referenzspannung (VR1) erzeugt wird;

- einen Schalter (S1), der zu dem ersten widerstand (R1) parallelgeschaltet ist;

- ebenfalls zwischen dem ersten (VS1) und dem zweiten Pol (Masse) die Reihenschaltung eines dritten Widerstandes (R3) mit einem vierten Widerstand (R4), über welchem eine Hilfsspannung (VR2) entsteht, wobei das Verhältnis des ersten (R1) zum zweiten (R2) Widerstandswert gleich dem Verhältnis des dritten (R3) zum vierten (R4) Widerstandswert ist; und

- einen Komparator (CCMP1), der die Referenzspannung (VR1) und die Hilfsspannung (VR2) vergleicht und den Schalter (S1) so steuert, daß er den ersten Widerstand (R1) kurzschließt, wenn die Referenzspannung (VR1) kleiner als die Hilfsspannung (VR2) wird, wodurch die Referenzspannung (VR1) der Hilfsspannung (VR2) folgt.

2. Referenzspannungs- (VR1) Erzeugungsschaltung gemäß Anspruch 1, dadurch gekennzeichnet, daß sie desweiteren einen zweiten Schalter (S2) enthält, der parallel zu dem vierten Widerstand (R4) liegt, und durch den Komparator (COMP1) auf eine solche Weise gesteuert wird, daß der vierte Widerstand (R4) kurzgeschlossen wird, wenn die Referenzspannung (VR1) geringfügig höher ist als die Hilfsspannung (VR2).

3. Referenzspannungs- (VR1) Erzeugungsschaltung gemäß Anspruch 2, dadurch gekennzeichnet, daß sie in einer Startimpuls-Erzeugungsschaltung verwendet wird, die einen Startimpuls (U) erzeugt, wenn eine zweite Versorgungsspannung (VS2), die zwischen einem dritten Pol (VS2) und dem zweiten Pol (Masse) bereitgestellt wird, einen vorgegebenen Wert (VS2S) erreicht, wobei der im wesentlichen konstante Wert (VS1S) erreicht wird, bevor der vorgegebene Wert (VS2S) erreicht wird, und wobei die Startimpuls-Erzeugungsschaltung desweiteren umfaßt:

- zwischen dem dritten (VS2) und dem zweiten Pol (Masse) die Reihenschaltung eines fünften Widerstandes (R6) mit einem sechsten Widerstand (R7), über welchem eine zweite Hilfsspannung (VT) erzeugt wird, welche die Referenzspannung (VR1) erreicht, wenn die zweite Versorgungsspannung (VS2) den vorgegebenen Wert (VS2S) erreicht; und

- einen zweiten Komparator (COMP2), der die zweite Hilfsspannung (VT) und die Referenzspannung (VR1) vergleicht und den Startimpuls (U) erzeugt, wenn die zweite Hilfsspannung (VT) die Referenzspannung (VR1) erreicht, und den zweiten Schalter auf eine solche Weise steuert, daß der vierte Widerstand (R4) kurzgeschlossen wird, wenn die zweite Hilfsspannung (VT) geringfügig höher ist als die Referenzspannung (VR1).

4. Referenzspannungs- (VR1) Erzeugungsschaltung gemäß Anspruch 3, dadurch gekennzeichnet, daß die Startimpuls-Erzeugungsschaltung desweiteren eine Versorgungsspannungs-Erkennungsschaltung enthält, die den zweiten Schalter (S2) auf eine solche Weise steuert, daß der vierte Widerstand (R4) kurzgeschlossen wird, wenn die zuerst erwähnte Versorgungsspannung (VS1) geringfügig höher ist als eine vorgegebene Schwellspannung.

5. Referenzspannungs- (VR1) Erzeugungsschaltung gemäß Anspruch 4, dadurch gekennzeichnet, daß die Versorgungsspannungs-Erkennungsschaltung zwischen dem ersten (VS1) und dem zweiten Polen (Masse) einen ersten Zweig enthält, der durch die Reihenschaltung der Hauptstrompfade eines ersten Transistors (T1) einer ersten Polarität und eines zweiten Transistors (T2) einer zweiten Polarität gebildet wird, sowie einen zweiten Zweig, der durch die Reihenschaltung des Hauptstrompfades eines dritten Transistors (T3) der ersten Polarität und eines siebenten Widerstandes (R5) gebildet wird, wobei die Steuerelektroden des ersten (T1) und dritten Transistors (T3) miteinander verbunden und an den Verbindungsknoten des ersten (T1) und zweiten (T2) Transistors angeschlossen sind, wobei eine Steuerelektrode des zweiten Transistors (T2) an den Verbindungsknoten zwischen dem dritten Transistor (T3) und dem fünften Widerstand (R5) und über ein Diodenmittel (D) an den ersten Pol (VS1) angeschlossen ist, wobei der letztgenannte Verbindungsknoten einen Ausgang der Versorgungsspannungs-Erkennungsschaltung bildet.

6. Referenzspannungs- (VR1) Erzeugungsschaltung gemäß Anspruch 5, dadurch gekennzeichnet, daß der zweite Schalter (S2) durch einen Ausgang eines logischen UND-Gatters (AND) gesteuert wird, dessen einer eingang an den Ausgang des zuerst erwähnten Komparators (COMP1) angeschlossen ist, dessen zweiter Eingang an den Ausgang der Versorgungsspannungs-Erkennungsschaltung angeschlossen ist und dessen dritter Ausgang an den Ausgang des zweiten Komparators (COMP2) angeschlossen ist.

**Revendications**

1. Circuit générateur de tension référence (VR1) alimenté par une source d'alimentation de tension (VSS) fournissant aux électrodes d'un premier (VS2) et d'un deuxième (TER) pôle une première tension d'alimentation (VS1) qui augmente jusqu'à une valeur (VS1S) sensiblement constante, dans lequel ledit circuit générateur de tension de référence comporte :

- entre lesdits premiers (VS1) et deuxième pâle (terre), le raccordement en série d'une première résistance (R1) et d'une deuxième résistance (R2) qui est shuntée par une capacitance (C) aux électrodes de laquelle ladite tension de référence (VR1) est générée ;
- un interrupteur (S1) raccordé en parallèle à ladite première résistance (R1) ;
- également entre lesdits premier (VS1) et deuxième (terre) pôles, le raccordement en série d'une troisième résistance (R3) et d'une quatrième résistance (R4) aux électrodes desquelles une tension auxiliaire (VR2) est développée, le rapport desdites première (R1) et deuxième (R2) valeurs de résistance étant égal à celui desdites troisième (R3) et quatrième (R4) valeurs de résistance ; et
- un comparateur (COMP1) camparant lesdites tensions de référence (VR1) et auxiliaire (VR2) et commandant ledit interrupteur (S1) de sorte qu'il courtcircuite ladite première résistance (R1) lorsque ladite tension de référence (VR1) devient inférieure à ladite tension auxiliaire (VR2), ladite tension de référence (VR1) suivant ainsi ladite tension auxiliaire.

2. Circuit générateur de tension de référence (VR1) suivant la revendication 1, caractérisé en ce qu'il comporte en outre un deuxième interrupteur (S2) en parallèle à ladite quatrième résistance (R4), et commandé par ledit comparateur (COMP1) de manière que ladite quatrième résistance (R4) est court-circuitée lorsque au moins ladite tension de référence (VR1) est supérieure à ladite tension auxiliaire (VR2).

3. Circuit générateur de tension de référence (VR1) suivant la revendication 2, caractérisé en ce qu'il est utilisé dans un circuit générateur d'impulsion de démarrage générant une impulsion de démarrage (U) lorsqu'une deuxième tension d'alimentation (VS2) fournie aux électrodes d'un troisième pôle (VS2) et dudit deuxième pôle (terre) atteint une valeur prédéterminée (VS2S), ladite valeur (VS1S) sensiblement constante étant atteinte avant que ladite valeur prédéterminée (VS2S) soit atteinte et ledit circuit générateur d'impulsion de démarrage comprenant en outre :

- entre lesdites troisième (VS2) et deuxième (terre) pôles, le raccordement en série d'une cinquième résistance (R6) et d'une sixième résistance (R7) aux électrodes desquelles est générée une deuxième tension auxiliaire (VT), qui atteint ladite tension de référence (VR1) lorsque ladite tension d'alimentation (VS2) atteint ladite valeur prédéterminée (VS2S) ; et

- un deuxième comparateur (COMP2) comparant ladite àeuxième tension auxiliaire (VT) et ladite tension de référence (VR1) et générant ladite impulsion de démarrage lorsque ladite deuxième tension auxiliaire (VT) atteint ladite tension de référence (VR1), et commandant ledit deuxième interrupteur de telle sorte que ladite quatrième résistance (R4) est court-circuitée lorsqu'au moins ladite deuxième tension auxiliaire (VT) est supérieure à ladite tension de référence (VR1).

4. Circuit générateur de tension de référence (VR1) suivant la revendication 3, caractérisée en ce que ledit circuit générateur d'impulsion de démarrage comporte en outre un circuit détecteur de tension d'alimentation commandant ledit deuxième interrupteur (S2) de telle manière que ladite quatrième résistance (R4) est court-circuitée lorsque au moins ladite tension d'alimentation mentionnée au départ (VS1) est supérieure à une tension seuil prédéterminée.

5. Circuit générateur de tension de référence (VR1) suivant la revendication 4, caractérisé en ce que ledit circuit détecteur de tension d'alimentation comporte, entre lesdits premier (VS1) et deuxième (terre) pôles, un premier branchement constitué par le couplage en série des chemins principaux d'un premier transistor (Ti) d'une première polarité et d'un deuxième transistor (T2) d'une deuxième polarité, et un second branchement constitué par le couplage en série d'un chemin principal d'un troisième transistor (T3) de ladite première polarité et d'une cinquième résistance (R5), des électrodes de commande desdits premier T1 et troisième T3 transistors étant raccordées les unes avec les autres et raccordés au noeud de couplage desdits premier (T1) et deuxième (T2) transistors, une électrode de commande dudit deuxième transistor (T2) étant couplée au noeud de couplage entre ledit troisième transistor (T3) et ladite cinquième résistance (R5), et par l'intermédiaire d'un moyen formant diode D, audit premier pôle (VS1), ce dernier noeud de couplage constituant une sortie dudit circuit détecteur de tension d'alimentation.

6. Circuit générateur de tension de référence (VR1) suivant la revendication 5, caractérisé en ce que ledit deuxième interrupteur (S2) est commandé par une sortie d'une porte ET logique (AND), dont une première entrée est couplée à une sortie dudit comparateur (COMP1) mentionné ci-dessus, dont une deuxième entrée est couplée à une sortie dudit circuit détecteur de tension d'alimentation, et dont une troisième entrée est couplée à une sortie dudit deuxième comparateur (COMP2).

FIG.1

EP 0 643 486 B1

FIG.2